# EUROPÄISCHE PATENTSCHRIFT

(11) **EP 2 950 693 B1**
(45) Veröffentlichungstag und Bekanntmachung des Hinweises auf die Patenterteilung: **27.12.2017**
(21) Anmeldenummer: 14701409.6
(22) Anmeldetag: 27.01.2014
(51) Int. Cl.: A47L 15/42, D06F 39/12, D06F 33/02, A47L 15/00, H04W 4/00

(54) **HAUSHALTSGERÄT**
DOMESTIC APPLIANCE
APPAREIL ÉLECTROMÉNAGER

(30) Priorität: 31.01.2013 DE 102013201575
(43) Veröffentlichungstag der Anmeldung: 09.12.2015
(73) Patentinhaber: BSH Hausgeräte GmbH, 81739 München (DE)
(72) Erfinder: HERING, Reinhard, 89438 Holzheim (DE); NISTOR, Paul, 89407 Dillingen (DE); WIRTH, Christian, 89407 Dillingen (DE)
(86) Internationale Anmeldenummer: PCT/EP2014/051527
(87) Internationale Veröffentlichungsnummer: WO 2014/118126

(56) Entgegenhaltungen:
- WO-A1-2004/052168
- WO-A1-2011/080146
- DE-A1-102005 058 667
- DE-A1-102008 055 017
- DE-A1-102009 000 524
- DE-U1- 9 207 677

## Beschreibung

Die vorliegende Erfindung betrifft ein Haushaltsgerät.

Es ist bekannt, Haushaltsgeräte, beispielsweise Kühlschränke, Waschmaschinen, Geschirrspülmaschinen oder Öfen, mit Kommunikationsmodulen auszustatten. Diese Kommunikationsmodule können einmal einen Datenaustausch zwischen verschiedenen Haushaltsgeräten ermöglichen. Weiterhin können solche Kommunikationsmodule dazu vorgesehen sein, mit Benutzerendgeräten, beispielsweise Smartphones, zu kommunizieren. Somit kann sich beispielsweise eine Bedienerperson über den Fortschritt eines Spülprogramms einer Spülmaschine per Smartphone informieren.

Beispielsweise beschreibt die WO 2011/080146 A1 ein Kommunikationsmodul für eine Geschirrspülmaschine. Dieses ist in eine vorderseitige Blende der Geschirrspülmaschine integriert.

Die DE 10 2009 000 524 A1 beschreibt eine Geschirrspülmaschine mit einem wannenförmigen Basisträger, auf dem ein Spülbehälter der Geschirrspülmaschine angeordnet ist.

Die DE 10 2005 058 667 A1 zeigt eine Geschirrspülmaschine mit einem Gehäuse und einer schwenkbar an dem Gehäuse befestigten Tür, die eine durch den Nutzer bedienbare Bedienvorrichtung an der Tür aufweist, welche mit einer in dem Gehäuse angeordneten Steuervorrichtung zum Steuern der Geschirrspülmaschine gekoppelt ist. Die Bedienvorrichtung und die Steuervorrichtung sind zum Signalaustausch über eine Licht leitende Verbindung miteinander gekoppelt.

Grundsätzlich gilt es, solche Kommunikationsmodule derart vorzusehen, dass sie möglichst wenig insbesondere durch Metallteile des Haushaltsgeräts abgeschirmt sind. Dadurch lässt sich die Reichweite einer in das Kommunikationsmodul integrierten Antenne verbessern bzw. ein Austausch von Daten wird somit erst ermöglich. Weiterhin sollen die Kommunikationsmodule in verschiedenen Varianten des Haushaltsgeräts einfach montierbar sein.

Vor diesem Hintergrund besteht eine Aufgabe der vorliegenden Erfindung darin, ein Haushaltsgerät bereitzustellen, welches ein Kommunikationsmodul aufweist, das möglichst wenig abgeschirmt ist und dadurch eine große Reichweite aufweist und ferner in unterschiedlichen Varianten des Haushaltsgeräts einfach montierbar ist.

Daher wird ein Haushaltsgerät mit einem Gehäuse, einem Basisträger und einem Kommunikationsmodul vorgeschlagen. Der Basisträger ist dazu ausgebildet, das Gehäuse am Boden abzustützen. Das Kommunikationsmodul ist zum drahtlosen Senden und/oder Empfangen von Daten eingerichtet. Das Kommunikationsmodul ist innerhalb des Basisträgers angeordnet. Das Kommunikationsmodul ist im Bereich einer vorderen Wand des Basisträgers angeordnet. Der Basisträger ist zumindest im Bereich angrenzend an das Kommunikationsmodul aus Kunststoff ausgebildet. Das Kommunikationsmodul ist zwischen der vorderen Wand und einer Stützrippe des Basisträgers angeordnet, wobei das Kommunikationsmodul in einen zwischen der vorderen Wand und der Stützrippe gebildeten Spalt eingesteckt ist.

Generell besteht aufgrund der Konstruktion von Gehäuse und Basisträger im Bereich des Basisträgers eine nur geringe Abschirmung. Entsprechend gut ist die Reichweite eines dort angebrachten Kommunikationsmoduls. Weiterhin bleibt der Basisträger bei verschiedenen Varianten eines Haushaltsgeräts grundsätzlich unverändert bzw. ist bei jedem Haushaltsgerät vorhanden. Entsprechend kann das Kommunikationsmodul bei allen Varianten in dem Basisträger untergebracht werden. So besteht beispielsweise bei der WO 2011/080146 A1 die Schwierigkeit, dass bei Einbaugeräten mit Fußleiste die Blende, welche das Kommunikationsmodul aufweist, nicht vorhanden ist. Entsprechend muss das Kommunikationsmodul bei solchen Varianten andernorts untergebracht werden, was die Komplexität der Variantenbildung erhöht sowie zusätzliche Logistikkosten mit sich bringen kann.

Mit "innerhalb des Basisträgers" ist gemeint, dass das Kommunikationsmodul ringsum von dem Basisträger umgeben ist. Dies schließt nicht aus, dass das Kommunikationsmodul in Varianten über den Basisträger abschnittsweise hinausragen kann. Insbesondere ist das Kommunikationsmodul an dem Basisträger befestigt. Beispielsweise kann das Kommunikationsmodul an dem Basisträger durch Einstecken in eine Aussparung befestigt sein.

Der Basisträger besteht teilweise oder vollständig aus Kunststoff.

Dadurch ist der Basisträger für elektromagnetische Strahlung zumindest teilweise durchlässig, so dass das Kommunikationsmodul nur geringfügig abgeschirmt wird. Erfindungsgemäß ist der Basisträger zumindest im Bereich angrenzend an das Kommunikationsmodul aus Kunststoff ausgebildet.

Das Kommunikationsmodul ist im Bereich einer vorderen Wand des Basisträgers angeordnet.

"Vordere Wand" meint die im Betrieb des Haushaltsgeräts einer Bedienerperson zugewandte Wand. Die vordere Wand ist im Unterschied zur hinteren Wand grundsätzlich frei, also nicht von einer Mauer oder dergleichen abgedeckt, so dass an dieser Stelle ein guter Empfang für das Kommunikationsmodul besteht. Grundsätzlich könnte das Kommunikationsmodul allerdings auch angrenzend an eine andere Wand des Basisträgers angeordnet sein.

Gemäß einer weiteren Ausführungsform ist die vordere Wand aus Kunststoff gebildet.

Dadurch wird im Bereich des Kommunikationsmoduls eine Abschirmung desselben minimiert.

Das Kommunikationsmodul ist zwischen der vorderen Wand und einer Stützrippe des Basisträgers angeordnet.

Durch Einstecken des Kommunikationsmoduls in einen zwischen der vorderen Wand und der Stützrippe gebildeten Spalt lässt sich das Kommunikationsmodul einfach an dem Basisträger befestigen.

Gemäß einer weiteren Ausführungsform erstrecken sich die vordere Wand und die Stützrippe parallel zueinander.

Dadurch kann das Kommunikationsmodul - je nach Variante des Haushaltsgeräts - einfache durch Verschieben in dem zwischen der vorderen Wand und der Stützrippe gebildeten Spalt unterschiedlich positioniert werden, um so variantenspezifischen Eigenarten Rechnung zu tragen. Beispielsweise kann so das Kommunikationsmodul an eine Stelle verschoben werden, welche von einem wasserführenden Schlauch beabstandet ist, welcher andernfalls den Empfang des Kommunikationsmoduls stören könnte.

Gemäß einer weiteren Ausführungsform ist das Kommunikationsmodul auf oder in einem gegenüber Schwingungen des Haushaltsgeräts isolierenden Dämpfungsmaterial angeordnet.

Dadurch kann das Kommunikationsmodul gegenüber Schwingungen des Haushaltsgeräts isoliert werden, was sich positiv auf die Lebensdauer des Kommunikationsmoduls auswirken kann. Durch eine Unterbringung des Kommunikationsmoduls in dem Dämpfungsmaterial lässt sich das Kommunikationsmodul platzsparend unterbringen.

Gemäß einer weiteren Ausführungsform ist das Kommunikationsmodul in einer nach oben offenen Aussparung in dem Dämpfungsmaterial angeordnet.

Dadurch lässt sich das Kommunikationsmodul einfach von oben in die Aussparung einschieben und dadurch an dem Basisträger befestigen.

Gemäß einer weiteren Ausführungsform ist das Dämpfungsmaterial zwischen der vorderen Wand und der Stützrippe angeordnet.

In dem zwischen der vorderen Wand und der Stützrippe gebildeten Spalt lässt sich das Dämpfungsmaterial einfach befestigen.

Gemäß einer weiteren Ausführungsform umfasst der Basisträger die vordere Wand, eine hintere Wand sowie zwei Seitenwände, welche miteinander ringsum und jeweils mit einer Bodenplatte zum Ausbilden einer Wanne verbunden sind.

Eine solche Wanne ist gut geeignet, die entsprechenden Komponenten des Haushaltsgeräts aufzunehmen, insbesondere einen Spülbehälter.

Gemäß einer weiteren Ausführungsform ist das Kommunikationsmodul dazu eingerichtet, mit zumindest einem anderen Kommunikationsmodul eines anderen Haushaltsgeräts oder einem Benutzerendgerät drahtlos zu kommunizieren.

Bei dem Benutzerendgerät kann es sich beispielsweise um ein Smartphone handeln.

Gemäß einer weiteren Ausführungsform ist das Kommunikationsmodul als WLAN- und/oder Bluetooth-Kommunikationsmodul ausgebildet.

Gemäß einer weiteren Ausführungsform ist das Haushaltsgerät als Geschirrspülmaschine ausgebildet.

Gemäß einer weiteren Ausführungsform trägt der Basisträger zusätzlich zu dem Gehäuse zumindest eine wasserführende Komponente.

Bei der wasserführenden Komponente kann es sich beispielsweise um einen Spülbehälter einer Geschirrspülmaschine handeln. Weiterhin kann die wasserführende Komponente als ein Pumpentopf ausgebildet sein, welcher an dem Basisträger befestigt ist. Noch weiterhin kann die wasserführende Komponente als Schlauch ausgebildet sein, welcher an dem Basisträger gehalten ist.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegte Figur näher erläutert.

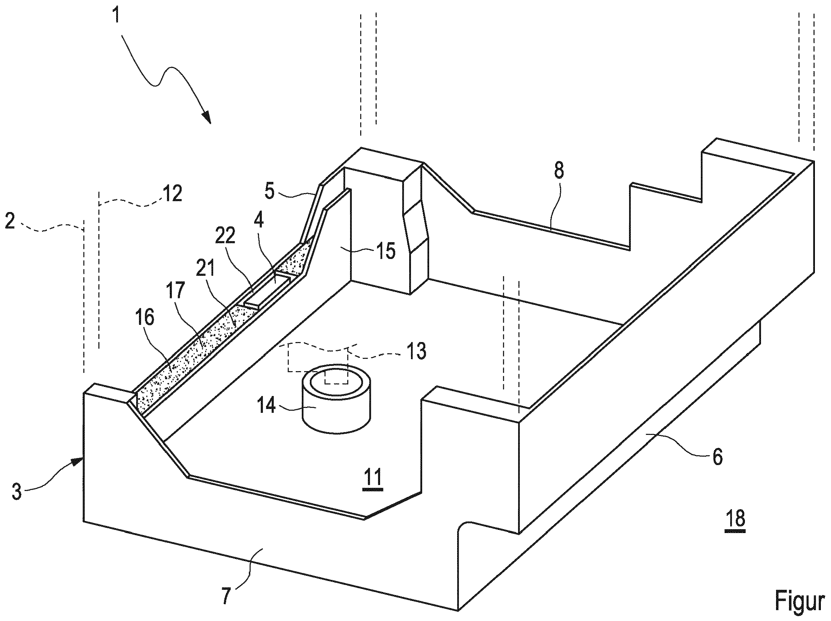

Die einzige Figur zeigt in einer perspektivischen Ansicht ausschnittsweise eine Geschirrspülmaschine gemäß einer Ausführungsform.

Das Haushaltsgerät in Form einer Geschirrspülmaschine 1 umfasst ein Gehäuse 2, welches lediglich schematisch dargestellt ist. Weiter umfasst die Geschirrspülmaschine 1 einen Basisträger 3, beispielsweise in Form einer Wanne. Ein Kommunikationsmodul 4 des Haushaltsgeräts 1 ist innerhalb des Basisträgers 3 angeordnet.

Der Basisträger 3 ist beispielsweise vollständig aus Kunststoff ausgebildet. Als Kunststoff kann beispielsweise Polypropylen verwendet werden. Der Basisträger 3 umfasst eine vordere Wand 5, welche in Einbaulage der Geschirrspülmaschine 1 einer Bedienerperson zugewandt ist. Ferner umfasst der Basisträger 3 gegenüberliegend der vorderen Wand 5 eine hintere Wand 6 sowie Seitenwände 7 und 8. Die Wände 5, 6, 7, 8 sind ringsum miteinander verbunden. Weiterhin sind die Wände 5, 6, 7, 8 mit einer Bodenplatte 11 des Basisträgers 3 verbunden. Insbesondere können die Wände 5, 6, 7, 8 und die Bodenplatte 11 einstückig, beispielsweise im Spritzgussverfahren, gebildet sein. Die so gebildete Wanne dient als Träger für insbesondere das Gehäuse 2, einen schematisch angedeuteten Spülbehälter 12 zur Aufnahme von Spülgut sowie verschiedener insbesondere wasserführender Komponenten der Geschirrspülmaschine 1. Beispielhaft ist ein Pumpentopf 13 beispielhaft gezeigt, welcher an einem Befestigungsabschnitt 14 an der Bodenplatte 11 befestigt ist. Somit stützt der Basisträger 3 im Wesentlichen sämtliche Komponenten der Geschirrspülmaschine 1 am Boden 18 ab, auf dem die Geschirrspülmaschine 1 steht.

Der Basisträger 3 weist ferner zumindest eine Stützrippe 15 auf, welche zusammen mit der vorderen Wand 5 einen Spalt 16 bildet. In den Spalt 16 ist das Kommunikationsmodul 4 eingesteckt und somit an dem Basisträger 3 befestigt. Die Stützrippe 15 kann sich parallel zur vorderen Wand 5 erstrecken und einstückig insbesondere mit der Bodenplatte 11 gebildet sein. Je nach Variante lässt sich das Kommunikationsmodul 4 somit auch an einer mit 17 bezeichneten Position anordnen.

Ferner kann der Spalt 16 mit einem Dämpfungsmaterial in Form eines Vlieses 21 gefüllt sein. Das Vlies 21 weist eine nach oben offene Aussparung 22 auf, in welche das Kommunikationsmodul 4 eingesetzt ist.

Das Kommunikationsmodul 4 kann dazu eingerichtet sein, mit Kommunikationsmodulen anderer Haushaltsgeräte, beispielsweise einem Backofen, oder auch einem Benutzerendgerät in Form eines Smartphones drahtlos zu kommunizieren. Hierbei kann das Kommunikationsmodul ein WLAN (Wireless Local Area Network) mit anderen Kommunikationsmodulen oder dem Benutzerendgerät bilden. Die Drahtloskommunikation kann beispielsweise über Bluetooth erfolgen. Das Kommunikationsmodul 4 weist dabei eine Einbauposition auf, in welcher es nur wenig oder gar nicht abgeschirmt ist, so dass es eine hohe Reichweite aufweist. Insbesondere die vordere Wand 5 aus Kunststoff ist für elektromagnetische Strahlung leicht zu durchdringen.

Obwohl die vorliegende Erfindung anhand von Ausführungsbeispielen beschrieben wurde, ist sie vielfältig modifizierbar.

### Verwendete Bezugszeichen:

- 1: Geschirrspülmaschine
- 2: Gehäuse
- 3: Basisträger
- 4: Kommunikationsmodul
- 5: vordere Wand
- 6: hintere Wand
- 7: Seitenwand
- 8: Seitenwand
- 11: Bodenplatte
- 12: Spülbehälter
- 13: Pumpentopf
- 14: Befestigungsabschnitt
- 15: Stützrippe
- 16: Spalt
- 17: Position
- 18: Boden
- 21: Vlies
- 22: Aussparung

## Patentansprüche

1. Haushaltsgerät (1) mit einem Gehäuse (2), einem Basisträger (3), welcher dazu ausgebildet ist, das Gehäuse (2) am Boden (18) abzustützen, und einem Kommunikationsmodul (4), welches zum drahtlosen Senden und/oder Empfangen von Daten eingerichtet ist, wobei das Kommunikationsmodul (4) innerhalb des Basisträgers (3) angeordnet ist, und wobei das Kommunikationsmodul (4) im Bereich einer vorderen Wand (5) des Basisträgers (3) angeordnet ist, **dadurch gekennzeichnet, dass** der Basisträger (3) zumindest im Bereich angrenzend an das Kommunikationsmodul (4) aus Kunststoff ausgebildet ist, dass das Kommunikationsmodul (4) zwischen der vorderen Wand (5) und einer Stützrippe (15) des Basisträgers (3) angeordnet ist, und dass das Kommunikationsmodul (4) in einen zwischen der vorderen Wand (5) und der Stützrippe (15) gebildeten Spalt (16) eingesteckt ist.

2. Haushaltsgerät nach Anspruch 1, **dadurch gekennzeichnet, dass** der Basisträger (3) vollständig aus Kunststoff besteht.

3. Haushaltsgerät nach Anspruch 1 oder 2, **dadurch gekennzeichnet, dass** die vordere Wand (5) aus Kunststoff gebildet ist.

4. Haushaltsgerät nach einem der Ansprüche 1 - 3, **dadurch gekennzeichnet, dass** sich die vordere Wand (5) und die Stützrippe (15) parallel zueinander erstrecken.

5. Haushaltsgerät nach einem der Ansprüche 1 - 4, **dadurch gekennzeichnet, dass** das Kommunikationsmodul (4) auf oder in einem gegenüber Schwingungen des Haushaltsgeräts (1) isolierenden Dämpfungsmaterial (21) angeordnet ist.

6. Haushaltsgerät nach Anspruch 5, **dadurch gekennzeichnet, dass** das Kommunikationsmodul (4) in einer nach oben offenen Aussparung (22) in dem Dämpfungsmaterial (21) angeordnet ist.

7. Haushaltsgerät nach Anspruch 5 oder 6, **dadurch gekennzeichnet, dass** das Dämpfungsmaterial (21) zwischen der vorderen Wand (5) und der Stützrippe (15) angeordnet ist.

8. Haushaltsgerät nach einem der Ansprüche 5 - 7, **dadurch gekennzeichnet, dass** das Dämpfungsmaterial (21) als Vlies ausgebildet ist.

9. Haushaltsgerät nach einem der Ansprüche 1 - 8, **dadurch gekennzeichnet, dass** der Basisträger (3) die vordere Wand (5), eine hintere Wand (6) sowie zwei Seitenwände (7, 8) umfasst, welche miteinander ringsum und jeweils mit einer Bodenplatte (11) zum Ausbilden einer Wanne verbunden sind.

10. Haushaltsgerät nach einem der Ansprüche 1 - 9, **dadurch gekennzeichnet, dass** das Kommunikationsmodul (4) dazu eingerichtet ist, mit zumindest einem anderen Kommunikationsmodul eines anderen Haushaltsgeräts oder einem Benutzerendgerät drahtlos zu kommunizieren.

11. Haushaltsgerät nach einem der Ansprüche 1 - 10, **dadurch gekennzeichnet, dass** das Haushaltsgerät (1) als Geschirrspülmaschine ausgebildet ist.

12. Haushaltsgerät nach Anspruch 11, **dadurch gekennzeichnet, dass** der Basisträger (3) zusätzlich zu dem Gehäuse (2) zumindest eine wasserführende Komponente (12, 13) trägt.

## Claims

1. Domestic appliance (1) with a housing (2), a base support (3) which is embodied to support the housing (2) on the floor (18) and a communication module (4) which is designed to send and/or receive data wirelessly, wherein the communication module (4) is disposed within the base support (3), and wherein the communication module (4) is disposed in the area of a front wall (5) of the base support (3), **characterised in that** the base support (3) is embodied as made of plastic, at least in the area adjacent to the communication module (4), the communication module (4) is disposed between the front wall (5) and a reinforcing rib (15) of the base support (3) and the communication module (4) is inserted into a gap (16) formed between the front wall (5) and the reinforcing rib (15).

2. Domestic appliance according to claim 1, **characterised in that** the base support (3) is completely made of plastic.

3. Domestic appliance according to claim 1 or 2, **characterised in that** the front wall (5) is formed of plastic.

4. Domestic appliance according to one of claims 1 to 3, **characterised in that** the front wall (5) and the reinforcing rib (15) extend parallel to one another.

5. Domestic appliance according to one of claims 1 to 4, **characterised in that** the communication module (4) is disposed on or in a damping material (21) isolated from vibrations of the domestic appliance (1).

6. Domestic appliance according to claim 5, **characterised in that** the communication module (4) is disposed in a recess (22) in the damping material (21) which is open at the top.

7. Domestic appliance according to claim 5 or 6, **characterised in that** the damping material (21) is disposed between the front wall (5) and the reinforcing rib (15).

8. Domestic appliance according to one of claims 5 to 7, **characterised in that** the damping material (21) is embodied as a fleece.

9. Domestic appliance according to one of claims 1 to 8, **characterised in that** the base support (3) comprises the front wall (5), a rear wall (6) as well as two side walls (7, 8), which are connected to each other at all ends and are each connected to a bottom plate (11) to form a trough.

10. Domestic appliance according to one of claims 1 to 9, **characterised in that** the communication module (4) is designed to communicate wirelessly with at least one other communication module of another domestic appliance or a user terminal.

11. Domestic appliance according to one of claims 1 to 10, **characterised in that** the domestic appliance (1) is embodied as a dishwasher.

12. Domestic appliance according to claim 11, **characterised in that** the base support (3) supports at least one water-bearing component (12, 13) in addition to the housing (2).

## Revendications

1. Appareil ménager (1) avec une carcasse (2), un support de base (3) exécuté afin d'appuyer la carcasse (2) sur le sol (18) et un module de communication (4) aménagé pour l'envoi et/ou la réception sans fil de données, dans lequel le module de communication (4) est disposé au sein du support de base (3) et dans lequel le module de communication (4) est disposé dans la zone d'une paroi avant (5) du support de base (3), **caractérisé en ce que** le support de base (3) est exécuté en plastique au moins dans la zone contiguë au module de communication (4), **en ce que** le module de communication (4) est disposé entre la paroi avant (5) et une nervure d'appui (15) du support de base (3) et **en ce que** le module de communication (4) est inséré dans une fente (16) constituée entre la paroi avant (5) et la nervure d'appui (15).

2. Appareil ménager selon la revendication 1, **caractérisé en ce que** le support de base (3) se compose intégralement de plastique.

3. Appareil ménager selon la revendication 1 ou 2, **caractérisé en ce que** la paroi avant (5) est exécutée en plastique.

4. Appareil ménager selon l'une des revendications 1 à 3, **caractérisé en ce que** la paroi avant (5) et la nervure d'appui (15) s'étendent parallèlement l'une à l'autre.

5. Appareil ménager selon l'une des revendications 1 à 4, **caractérisé en ce que** le module de communication (4) est disposé sur ou dans un matériau amortissant (21) isolant contre les vibrations de l'appareil ménager (1).

6. Appareil ménager selon la revendication 5, **caractérisé en ce que** le module de communication (4) est disposé dans un évidement (22) ouvert vers le haut dans le matériau amortissant (21).

7. Appareil ménager selon la revendication 5 ou 6, **caractérisé en ce que** le matériau amortissant (21) est disposé entre la paroi avant (5) et la nervure d'appui (15).

8. Appareil ménager selon l'une des revendications 5 à 7, **caractérisé en ce que** le matériau amortissant (21) est exécuté sous forme de matériau non tissé.

9. Appareil ménager selon l'une des revendications 1 à 8, **caractérisé en ce que** le support de base (3) englobe la paroi avant (5), une paroi arrière (6) ainsi que deux parois latérales (7, 8) reliées l'une à l'autre sur le pourtour et respectivement à une plaque de fond (11) afin de constituer un bac.

10. Appareil ménager selon l'une des revendications 1 à 9, **caractérisé en ce que** le module de communication (4) est aménagé afin de communiquer sans fil avec au moins un autre module de communication d'un autre appareil ménager ou un terminal utilisateur.

11. Appareil électroménager selon l'une des revendications 1 à 10, **caractérisé en ce que** l'appareil ménager (1) est exécuté sous forme de lave-vaisselle.

12. Appareil ménager selon la revendication 11, **caractérisé en ce que** le support de base (3) porte, outre le carter (2), au moins un composant à circulation d'eau (12, 13).
